Europäisches Patentamt

**European Patent Office**

**Office européen des brevets**

(19)

(11) Publication number: **0 017 343**

**A1**

(12)

# EUROPEAN PATENT APPLICATION

(21) Application number: **80300648.5**

(22) Date of filing: **04.03.80**

(51) Int. Cl.³: **H 02 H 7/20**
 **H 04 B 1/04, H 03 B 11/10**
 **H 03 K 17/08**

(30) Priority: **13.03.79 GB 7908897**

(43) Date of publication of application:
 **15.10.80 Bulletin 80/21**

(84) Designated Contracting States:
 **DE FR GB IT NL SE**

(71) Applicant: **DECCA LIMITED**
 **Decca House 9 Albert Embankment**
 **London SE1 7SW(GB)**

(72) Inventor: **O'Brien, Richard Anthony**
 **25 Fairfax Street**
 **Newton, Massachusetts 02165(US)**

(74) Representative: **Horton, Andrew Robert Grant et al,**
 **BOULT, WADE & TENNANT 27 Furnival Street**
 **London, EC4A 1PQ(GB)**

(54) **Radio frequency generators.**

(57) A radio frequency generator comprises a set of switching transistors (1 to 4) which drive a radio frequency filter (5,6) of which an inductor (6) is tightly coupled to a coil (15) which feeds a bridge rectifier (17). The rectifier (17) is biassed by the source of direct current and begins its rectifying action when the load current becomes excessive. The load current becomes excessive as a result for instance of mismatch of the antenna (7,8,9). The arrangement provides protection against high load currents and thereby protects the switching elements (1 to 4) from damage.

FIG. 2.

EP 0 017 343 A1

Croydon Printing Company Ltd.

"RADIO FREQUENCY GENERATORS"

This invention relates to a radio frequency generator which incorporates a switching inverter which drives a filter to provide an output at a radio frequency for feeding a transmitting antenna. The inverter may assume any one of a variety of forms, but usually provides a square wave signal with the aid of solid state switches which control power switches either directly or via a coupling transformer. The combination of an inverter and a radio frequency filter, such as a series resonance circuit, can provide a very efficient source of radio frequency power. However, accidents such as mismatch at the load or flash over at the antenna's insulator can easily destroy the solid state switches and although various protective circuits and devices have been devised, their failure rate has been so high as to discourage the use of switching inverters for radio frequency generators.

One object of the present invention is to provide

0017343

a generator with an improved protection against the effects of high load current due to mismatch.

According to the invention, a radio frequency generator comprises a switching inverter which drives a radio-frequency filter and includes a series reactance and a rectifier which is coupled to that reactance and is biassed such that its rectifying action limits the inverter's switching current and protects the switching elements of the inverter.

It is preferable that the rectifier, which may be constituted by a bridge rectifier tightly coupled to an inductor of a series resonance circuit constituting the aforementioned filter, be biassed to provide substantial rectification only when the radio frequency current through the series reactance exceeds the radio frequency current in normal conditions of loading. The rectifier may be biassed by the source of direct current that feeds the switching inverter and to return rectified current to that source. The rectifier will limit the radio frequency voltage across the series reactance and thereby limit the current through it; this action limits the current through the switches of the inverter and thereby protects them.

One embodiment of the invention and a modification thereof will now be described by way of example with

0017343

reference to the accompanying drawings, in which:

Figure 1 is an explanatory diagram of a radio frequency generator comprising a switching inverter and a radio frequency filter;

Figure 2 is a circuit diagram of one embodiment of the invention, some ancillary circuits having been omitted for simplicity; and

Figure 3 illustrates a modification of part of the embodiment illustrated by Figure 2.

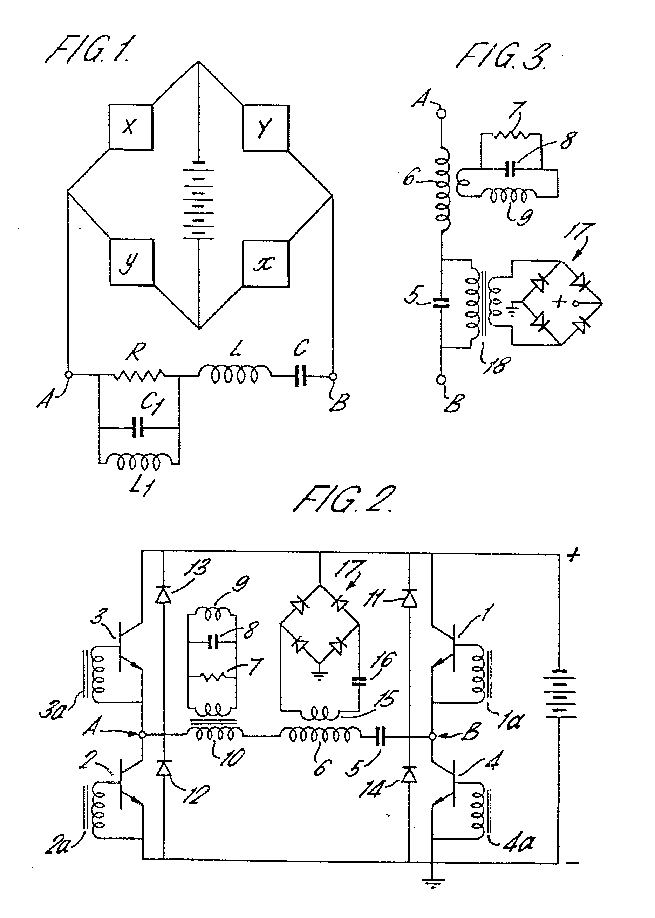

Figure 1 illustrates an inverter which converts direct current from a source, such as a battery to a filtered radio frequency signal flowing in a load resistance R. The pairs of switches $(X,x)$ and $(Y,y)$ are alternately switched for equal periods, the switching being at the desired radio frequency. A square wave voltage appears at the terminals A and B. The impedance of the series resonant circuit constituted by the inductor L and the capacitor C is nearly zero at the desired radio frequency and is substantially greater at the harmonics of that frequency. The unloaded quality factor (Q) of the resonant circuit is high, for example of the order of 250. The reactance of the inductor or capacitor at a resonance is chosen to be approximately six times the impedance of the load resistor R; the loaded quality factor is 6.

The parallel tuned circuit comprising the inductor $L_1$

-4-

and the capacitor $C_1$ is resonant at the chosen radio frequency. The unloaded quality factor is comparatively high whereas the loaded quality factor, when coupled to the load resistor R is preferably about 2.

If, in the arrangement shown in Figure 1, the impedance of the switches and the battery are approximately zero and the load resistance is short circuited, the current through the switches can rise to forty times the normal current and destroy the switches. If the load resistor is removed or open circuited, the high impedance of the parallel resonance circuit is in series between the terminals A and B and the switching current is reduced to nil.

Figure 2 is a simplified circuit diagram of one embodiment of the invention. In this embodiment, transistors 1 and 2 correspond to the switches Y and y and the transistors 3 and 4 correspond to the switches X and x in Figure 1. Drive signals are applied to the base/emitter junctions of these transistors by the secondaries 1a to 4a respectively of respective transformers which may be driven by switching transistors in accordance with known practice. The series resonant circuit of Figure 1 is constituted in this embodiment by the capacitor 5 and the inductor 6, the load resistor R by the resistor 7 and the parallel resonant circuit by the

-5-

capacitor 8 and the inductor 9. A transformer 10 of which the primary winding is in series with the series resonant circuit isolates the load in respect of direct current from the switching circuit. A particular impedance ratio between the primary and secondary circuits of this transformer may be obtained by alteration of the turns ratio of the transformer.

Diodes 11 to 14 respectively are connected across the collector/emitter junctions of the transistors 11 to 14. The purpose of these diodes is the prevention of the open circuiting of the filter network between the terminals A and B if all the transistors are momentarily non-conductive. The durations of the on and off periods of the switching voltages applied to the bases of the transistors 1 to 4 are preferably arranged so that transistors 1 and 4 or the transistors 3 and 4 are not simultaneously conductive. The choice of switching wave form is dependent on the storage delay time of the transistors.

It may be explained that the load current may be shared by a plurality of switching circuits in parallel and that if desired part of the radio frequency filter may be constituted by a set of parallel inductors or capacitors, one each for each of the parallel switching circuits as described in UK Patent Specification No. 1483584. Normally the switching circuits would be mounted on removable boards; but the diodes 11 to 14 need not be mounted on these boards and, if they are not, the generator may continue to operate even if one of the parallel switching circuits is removed.

The embodiment shown in Figure 2 is provided with a protective arrangement which comprises a coil, tightly coupled to the inductor 6, a capacitor 16, which compensates for the leakage inductance of the coupling coil and a bridge rectifier 17 which is biassed by the voltage of the source of direct current, namely the battery which in this embodiment serves the transistors 1 to 4. The coil 15 and its coupling to the inductor 6 is selected to provide a voltage which will just produce rectifying action in the bridge rectifier when the resistive loading of the radio frequency filter is normal and tuning is proper, that is to say the currents and voltages from the transistor switches 1 to 4 are in phase. If the load resistance is altered, whether by accident or otherwise, to demand more current from the transistors, the increased flow of rectified current will prevent any substantial rise in the current required of the transistors. In practice, if the normal current is six amperes for a set of four switching transistors as shown, the current may be limited to about seven amperes when the load resistor is short circuited and the direct supply current would fall to about one ampere, six of the seven amperes being returned to the battery 19 by the rectifier.

The radio frequency filter shown in Figure 2 is often called a zero phase-shift match, because it provides either zero or $180^{\circ}$ phase shift between the current through the load resistor and the series current between the terminals A and B. Sometimes phase quadrature matching may be desirable. If it is provided, an open circuit at the load reduces the impedance between the terminals A and B and limitation of the current between A and B is required just as it is for the circuit which has been particularly described.

Figure 3 illustrates a modification of the filter network between the terminals A and B and the associated rectifier. In the modification, a transformer 18 in parallel with the capacitor 5 couples the rectifier 17 to the capacitor rather than the inductor 6.

CLAIMS:

1. A radio frequency generator comprising a switching inverter (1,2,3,4), which drives a radiofrequency filter (5,6) and includes a series reactance (6) and a rectifier (17) which is coupled to that reactance and is biassed such that its rectifying action limits the flow of current through the inverter.

2. A radio frequency generator according to claim 1, in which the rectifier (17) conducts current back to a source (19) which energises the switching inverter with direct current.

3. A radio frequency generator according to claim 1 or claim 2, in which the rectifier (17) comprises a bridge rectifying network which is inductively coupled to the aforementioned reactance.

4. A radio frequency generator according to any foregoing claim, in which the filter (5,6) is such that the currents through the reactance (6) and a load (7) are in phase and the rectifying action of the rectifier is sufficient to protect the said elements if the load is short-circuited.

5. A radio frequency generator according to any of claims 1 to 4, in which the filter is such that the currents through the reactance and a load are in phase quadrature and the rectifying action of the rectifier is sufficient to protect the said elements of the load is open-circuit.

ARGH/BMS/DR/FA9043

**FIG.1.**

**FIG.3.**

**FIG.2.**

## European Patent Office — EUROPEAN SEARCH REPORT

Application number

EP 80 30 0648

| | DOCUMENTS CONSIDERED TO BE RELEVANT | | CLASSIFICATION OF THE APPLICATION (Int. Cl.3) |
|---|---|---|---|
| Category | Citation of document with indication, where appropriate, of relevant passages | Relevant to claim | |
| | US – A – 4 058 742 (W.J. O'BRIEN) <br> * column 11, line 23 and following; fig. 1 * <br> -- | 1 | H 02 H 7/20 <br> H 04 B 1/04 <br> H 03 B 11/10 <br> H 03 K 17/08 |
| | US – A – 3 517 265 (R.W. BRADFORD) <br> * fig. 1 * <br> -- | 1 | |
| | US – A – 3 721 836 (W.E. RIPPEL) <br> * column 14, line 25 and following; fig. 16 * <br> -- | 2 | |
| | AT – B – 289 234 (SIEMENS AG) <br> * fig. * <br> -- | 3 | TECHNICAL FIELDS SEARCHED (Int.Cl.3) <br><br> H 02 H 7/00 <br> H 03 B 11/00 <br> H 03 K 17/08 |
| A | DD – A – 94 433 (S. PECKELSEN) <br> * fig. * <br> -- | | H 04 B 1/00 |
| A | US – A – 4 059 801 (P.R. JOHANNESSEN et al.) <br> * fig. 1, 2 * <br> -- | | |
| A | US – A – 3 769 586 (J.M. SHAPIRO et al.) <br> * fig. * <br> -- | | CATEGORY OF CITED DOCUMENTS |
| A | US – A – 3 424 993 (P.L. CLAR) <br> * fig. 1 to 3 * <br> -- | | X: particularly relevant <br> A: technological background <br> O: non-written disclosure <br> P: intermediate document <br> T: theory or principle underlying the invention <br> E: conflicting application <br> D: document cited in the application <br> L: citation for other reasons |
| A | US – A – 3 379 955 (P.W. KOETSCH) <br> * fig. 1 to 3 * <br> ---- | | |
| | | | &: member of the same patent family, corresponding document |

X  The present search report has been drawn up for all claims

| Place of search | Date of completion of the search | Examiner |
|---|---|---|
| Berlin | 05-06-1980 | BREUSING |

EPO Form 1503.1  06.78